(19)

Europäisches
Patentamt
European
Patent Office
Office européen
des brevets

(11) **EP 3 896 680 A1**

(12) **EUROPEAN PATENT APPLICATION**
published in accordance with Art. 153(4) EPC

(43) Date of publication:
**20.10.2021 Bulletin 2021/42**

(21) Application number: **19926512.5**

(22) Date of filing: **25.10.2019**

(51) Int Cl.:
*G09F 9/30* *(2006.01)*

(86) International application number:
**PCT/CN2019/113462**

(87) International publication number:
**WO 2020/215639 (29.10.2020 Gazette 2020/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.04.2019 CN 201910323557**

(71) Applicant: **Kunshan Go-Visionox
Opto-Electronics Co., Ltd.
Kunshan, Jiangsu 215300 (CN)**

(72) Inventors:
• **LIU, Renjie
Jiangsu 215300 (CN)**
• **CHEN, Lingyan
Jiangsu 215300 (CN)**

(74) Representative: **Arnold & Siedsma
Bezuidenhoutseweg 57
2594 AC The Hague (NL)**

(54) **FLEXIBLE MODULE STRUCTURE AND DISPLAY APPARATUS**

(57)    The present disclosure relates to the field of flexibility technology and discloses a flexible module structure and a display apparatus. A flexible module structure, includes: a flexible panel, having a bendable part; a rotating shaft mechanism, attached to a surface of the bendable part and comprising a contact surface attached to the surface of the bendable part; and a strain gauge device, at least partially disposed on the bendable part. When the bendable part has a buckling deformation, the strain gauge device is configured to acquire a deformation amount of the bendable part and give a feedback to the rotating shaft mechanism, and the rotating shaft mechanism reduces a distance between a neutral surface and the contact surface of the rotating shaft mechanism according to the deformation amount.

FIG. 1

**Description**

**CROSS REFERENCE TO RELATED APPLICATIONS**

The present disclosure refers to the Chinese patent application No. 201910323557.1 with a title of "FLEXIBLE MODULE STRUCTURE AND DISPLAY APPARATUS" filed on April 22, 2019 which is incorporated into the present disclosure by reference.

**TECHNICAL FIELD**

The present disclosure relates to the field of flexibility technology, in particular, to a flexible module structure and a display apparatus.

**BACKGROUND**

With development of flexibility technologies such as a flexible display screen technology, flexible modules have become more and more widely used. A flexible module is a module structure that may be bent for a certain angle and recover to an initial state.

However, a current flexible module structure generally includes a plurality of layers overlapped. In practice, during repeated bending and curling of the flexible module structure, it is easy for adjacent layers to separate from each other, thus damaging and disabling part of the flexible module structure.

**SUMMARY**

An objective of embodiments in the present disclosure is to provide a flexible module structure and a display apparatus to reduce possibility of separation and debonding between adjacent layers during bending and deformation of the flexible module structure.

In order to address the above technical problem, an embodiment of the present disclosure provides a flexible module structure, including: a flexible panel, having a bendable part; a rotating shaft mechanism, attached to a surface of the bendable part and including a contact surface attached to the surface of the bendable part; and a strain gauge device, at least partially disposed on the bendable part. When the bendable part has a buckling deformation, the strain gauge device is configured to acquire a deformation amount of the bendable part, and the rotating shaft mechanism is configured to reduce a distance between a neutral surface and the contact surface of the rotating shaft mechanism according to the deformation amount.

An embodiment of the present disclosure further provides a display apparatus, including: the flexible module structure described above, a film packaging layer disposed on the flexible module structure and a light-transmitting layer disposed on the film packaging layer.

In this embodiment, the flexible module structure includes a flexible panel, a rotating shaft mechanism and a strain gauge device. Herein, the flexible panel has a bendable part, and the rotating shaft mechanism is disposed on a surface of the bendable part and is attached to the surface of the bendable part through a contact surface. The strain gauge device is disposed on the bendable part. When the bendable part has a buckling deformation, the rotating shaft mechanism and the strain gauge device are driven to deform synchronously. The strain gauge device can acquire a deformation amount of the bendable part and transmits the deformation amount to the rotating shaft mechanism. The rotating shaft mechanism adjusts its own deformation according to the deformation amount of the bendable part, so that a distance between a neutral surface and the contact surface of the rotating shaft mechanism is smaller than or equal to a preset threshold. Because a length of the neutral surface of the rotating shaft mechanism remains unchanged during the deformation of the rotating shaft mechanism, the neutral surface of the rotating shaft mechanism does not generate a deformation stress. In addition, a part of the rotating shaft mechanism with smaller distance away from the neutral surface bears a smaller deformation stress. The distance between the neutral surface and the contact surface of the rotating shaft mechanism is reduced in the rotating shaft mechanism, so that the deformation stress of the contact surface becomes smaller. Even when the distance between the neutral surface and the contact surface of the rotating shaft mechanism is reduced to zero, the contact surface does not generate a deformation stress. Therefore, a pressure applied to the flexible panel by the rotating shaft mechanism is reduced or even eliminated, thereby achieving the objective of reducing the possibility of separation and debonding between the flexible panel and the rotating shaft mechanism during bending and deformation process.

Further, the strain gauge device includes a strain unit and a voltage acquisition unit electrically connected with the strain unit. Herein, when the bendable part has a buckling deformation, the voltage acquisition unit is configured to acquire a voltage change value to acquire a resistance change value of the strain unit according to the voltage change value, and acquire the deformation amount according to the resistance change value. The strain gauge device is configured to include the strain unit and the voltage acquisition unit electrically connected with the strain unit, and the deformation amount of the bendable part is acquired by using a feature that the resistance of the strain unit changes with a shape of the strain unit. In this way, the strain gauge device has a simpler structure.

Further, the four resistance elements are connected to form a Wheatstone bridge circuit. The connection is simple and can prevent current in the circuit from being too small/large due to too large/small resistance value of a strain resistance element resulted from deformation of the strain resistance element. In this way, not only the circuit is protected, but accuracy of a voltage change amount acquired by the voltage acquisition unit is improved.

Further, there is one strain resistance element disposed in a one-fourth bridging manner. By using one strain resistance element, cost can be reduced. In addition, one strain resistance element is disposed in a one-fourth bridging manner, which has simple connection and can simplify a producing process.

Further, there are two strain resistance elements disposed in a half bridging manner. The two strain resistance elements can perform effective temperature compensation, thereby improving accuracy of a measurement result. In addition, the two strain resistance elements are disposed in a half bridging manner, which can further improve accuracy of the measurement result.

Further, there are four strain resistance elements disposed in a full bridging manner. The four strain resistance elements can perform effective temperature compensation, thereby improving accuracy of a measurement result. In addition, the four strain resistance elements are disposed in a full bridging manner, which can further improve accuracy of the measurement result.

Further, the flexible panel is a flexible display panel including a pixel unit, and the strain gauge device is electrically connected to a drive circuit of the pixel unit. Through electrically connecting the strain gauge device with the drive circuit of the pixel unit, the circuit structure of the flexible display panel itself can be used effectively, thereby it is not necessary to provide a additional power supply circuit for the strain gauge device, effectively simplifying the flexible module structure and reducing preparation cost and processing requirement to the flexible module structure.

Further, the rotating shaft mechanism includes a strain surface disposed opposite to the contact surface, and the rotating shaft mechanism includes a recess protruding from the strain surface towards the contact surface. By setting on the rotating shaft mechanism the recess protruding from the strain surface towards the contact surface, when the rotating shaft mechanism bends and deforms, the recess can reduce a stress of the strain surface and make the neutral surface closer to the contact surface.

## BRIEF DESCRIPTION OF THE DRAWINGS

FIG. 1 is a schematic diagram of a flexible module structure provided in an embodiment of the present disclosure.

FIG. 2 is a schematic diagram of a circuit structure of a strain unit in the flexible module structure provided in an embodiment of the present disclosure.

FIG. 3 is a schematic diagram of a position disposed for a strain resistance element in the flexible module structure provided in an embodiment of the present disclosure.

FIG. 4 is a schematic diagram of the flexible module structure provided in FIG. 3 added with a further strain resistance element.

FIG. 5 is a schematic diagram of the flexible module structure provided in FIG. 3 added with a further strain resistance element.

FIG. 6 is a schematic diagram of the flexible module structure provided in FIG. 5 with a changed position of the strain resistance element.

FIG. 7 is a schematic diagram of the flexible module structure provided in FIG. 5 added with further strain resistance elements.

FIG. 8 is a schematic diagram of the flexible module structure provided in FIG. 7 with changed positions of the strain resistance elements.

FIG. 9 is a schematic diagram of the flexible module structure provided in FIG. 7 with changed positions of the strain resistance elements.

FIG. 10 is a schematic cross-sectional view of a turning mechanism in the flexible module structure provided in an embodiment of the present disclosure.

FIG. 11 is a flow chart of an operation principle of the flexible module structure provided in an embodiment of the present disclosure.

FIG. 12 is a schematic diagram of a display apparatus provided in the present disclosure.

## DETAILED DESCRIPTION

In order to make the objective, the technical solutions and the advantages of the present disclosure clearer, embodiments of the present disclosure are described clearly and completely with reference to the drawings for the embodiments in the present disclosure. It is evident that the embodiments described are only some rather than all embodiments of the present disclosure. Based on the embodiments of the present disclosure, all other embodiments obtained by those skilled in the art without any inventive effort fall into the protection scope of the present disclosure.

For a flexible module structure, there is a problem that during bending and curling of the flexible module structure, it is easy for adjacent layers to separate and debond from each other, thus damaging the flexible module structure.

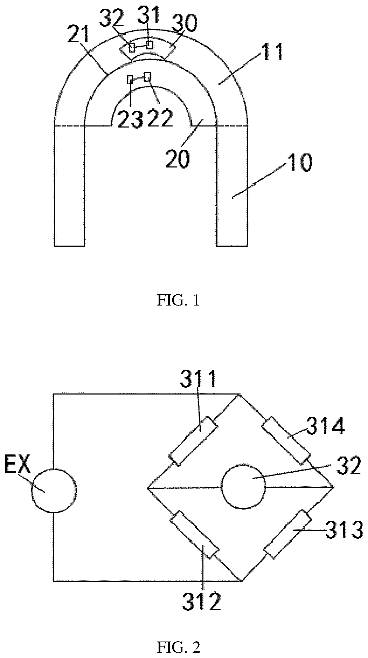

Based on the above reason, an embodiment of the present disclosure provides a flexible module structure and a display apparatus. As shown in FIG. 1, the flexible module structure includes a flexible panel 10, a rotating shaft mechanism 20 and a strain gauge device 30. The flexible panel 10 includes a bendable part 11, the rotating shaft mechanism 20 is attached to a surface of the bendable part 11, and the strain gauge device 30 is at least partially disposed on the bendable part 11. Herein, the rotating shaft mechanism 20 includes a contact surface 21 attached to the surface of the bendable part 11. The strain gauge device 30 may be embedded in the bendable part 11 as shown in FIG. 1, or may be attached to the surface of the bendable part 11, or may be partly embedded in the bendable part 11 and partly attached to the surface of the bendable part 11. Specifically, the strain gauge device 30 may be disposed flexibly according to practice need and is not defined herein. When the bendable part 11 has a buckling deformation, the strain gauge device 30 acquires a deformation amount of the bendable part 11 and gives a feedback to the rotating shaft mechanism 20. The rotating shaft mechanism 20 adjusts its own deformation according to the deformation amount of the bendable part 11 to reduce a distance between a neutral surface and the contact surface 21 of the rotating shaft mechanism 20. In this embodiment, the shorter the distance between the neutral surface and the contact surface 21 of the rotating shaft mechanism 20, the smaller the pressure on the bendable part 11 by the rotating shaft mechanism 20. In addition, in this embodiment, when the distance between the neutral surface of the rotating shaft mechanism 20 and the contact surface 21 is reduced to 0, the neutral surface and the contact surface 21 of the rotating shaft mechanism 20 are overlapped. In this case, the contact surface 21 does not bear a stress and thus does not generate a pressure on the bendable part 11.

When the rotating shaft mechanism 20 has a buckling deformation with the bendable part 11, a surface at a side of the rotating shaft mechanism 20 towards the bending direction is compressed, while a surface at a side of the rotating shaft mechanism 20 away from the bending direction is stretched. For the rotating shaft mechanism 20, between the compressed surface and stretched surface there is a surface whose length remains unchanged and is defined as a neutral surface. Because the length of the neutral surface remains unchanged, in the case when the rotating shaft mechanism 20 has a buckling deformation with the bendable part 11, the neutral surface is neither compressed or stretched and does not generate a bending stress. Parts of the rotating shaft mechanism 20 at two sides of the neutral surface may respectively generate a tensile stress and a compressive stress due to the stretch and the compression. A part of the rotating shaft mechanism 20, which is closer to the neutral surface, has a smaller deformation and correspondingly generates smaller tensile stress/compressive stress in the rotating shaft mechanism 20.

In the flexible module structure provided in this embodiment, the strain gauge device 30 is disposed on the bendable part 11 of the flexible panel 10. When the bendable part 11 has a deformation, the strain gauge device 30 acquires the deformation amount of the bendable part 11, and the rotating shaft mechanism 20 adjusts the deformation of the rotating shaft mechanism 20 according to the acquired deformation amount of the bendable part 11, reducing the distance between the neutral surface and the contact surface 21 of the rotating shaft mechanism 20. A distance between the neutral surface and the contact surface 21 of the rotating shaft mechanism 20 becomes smaller, so that a tensile stress/compressive stress generated at the contact surface 21 of the rotating shaft mechanism 20 is reduced, and a pressure applied on the bendable part 11 by the rotating shaft mechanism 20 is also reduced. In this way, the pressure on the flexible panel 10 by the rotating shaft mechanism 20 is reduced or even eliminated, thereby achieving the objective of reducing a possibility of separation and debonding between the flexible panel 10 and the rotating shaft mechanism 20 during bending process.

In addition, in this embodiment, the rotating shaft mechanism 20 includes a drive member 22 and an elastic member 23 connected to the drive member 22. When the bendable part 11 has a buckling deformation, the strain gauge device 30 acquires a deformation amount of the bendable part 11 and feeds back the acquired deformation amount of the bendable part 11 to the drive member 22. The drive member 22 adjusts the elastic member 23 according to the deformation amount of the bendable part 11 to reduce the distance between the neutral surface and the contact surface 21 of the rotating shaft mechanism 20. For example, when the rotating shaft mechanism 20 bends inward, the contact surface 21 of the rotating shaft mechanism 20 is stretched, and the contact surface 21 is located at a stretched side of the neutral surface of the rotating shaft mechanism 20 and generates a tensile stress for recovery to the original state. Therefore, the elastic member 23 is adjusted by the drive member 22, so that the elastic member 23 generates an elastic force with a direction opposite to a direction of the tensile stress. The elastic force generated by the elastic member 23 offsets part of or all of the tensile stress generated due to deformation of the rotating shaft mechanism 20. Because part of or all of the tensile stress is offset by the elastic force generated by the elastic member 23, the tensile stress and the compressive stress generated respectively at two sides of the neutral surface of the rotating shaft mechanism 20 are unbalanced and the tensile stress is smaller than the compressive stress. Under action of the compressive stress, the neutral surface moves toward the stretched side in the rotating shaft mechanism 20, thereby the distance between the neutral surface and the contact surface 21 of the rotating shaft mechanism 20 is smaller than or equal to a preset threshold.

In this embodiment, the drive member 22 is a motor and the elastic member 23 is a torsion spring. Cost is low when a drive member is set as a motor and the elastic member is set as a torsion spring.

In this embodiment, the strain gauge device 30 includes a strain unit 31 and a voltage acquisition unit 32 electrically connected with the strain unit 31. Herein, a resistance value of the strain unit 31 changes with its shape. When the bendable part 11 has a buckling deformation, the voltage acquisition unit 32 acquires a voltage change value in a circuit to acquire a resistance change value of the strain unit 31 according to the voltage change value, acquires a deformation amount of the strain unit 31 according to the resistance change value, and acquires the deformation amount of the bendable part 11 according to the deformation amount of the strain unit 31. The strain gauge device 30 is configured to include the strain unit 31 and the voltage acquisition unit 32 electrically connected with the strain unit 31, and the deformation amount of the bendable part 11 is acquired by using a feature that the resistance of the strain unit 31 changes with the shape of the strain unit 31; in this way, the strain gauge device 30 has a simpler structure.

In this embodiment, as shown in FIG. 2, the strain unit 31 at least includes four resistance elements, such as a first resistance element 311, a second resistance element 312, a third resistance element 313 and a fourth resistance element 314. Herein, the first resistance element 311 and the second resistance element 312 are connected in series, and the third resistance element 313 and the fourth resistance element 314 are connected in series, so that a first arm and a second arm connected in series, and a third arm and a fourth arm connected in series in a Wheatstone bridge circuit are formed. One end of the voltage acquisition unit 32 is electrically connected to a connecting point between the first resistance element 311 and the second resistance element 312, and the other end of the voltage acquisition unit 32 is electrically connected to the third resistance element 313 and the fourth resistance element 314. The four resistance elements includes at least one strain resistance element, and the fourth resistance element 314 is set as the strain resistance element. The above is only one specific example of the strain unit 31 but does not constitute a limitation. In another embodiment of the present disclosure, the deformation amount of the bendable part 11 may be obtained through another structure, for example, a deformation sensor using another principle, and no more examples therefor are provided herein.

In this embodiment, the fourth resistance element 314 is a strain gauge, which is a specific example in this embodiment and does not constitute a limitation. In another embodiment of the present disclosure, the fourth resistance element 314 may be another particular element, for which no more examples are provided herein.

In addition, in this embodiment, the first resistance element 311, the second resistance element 312, the third resistance element 313 and the fourth resistance element 314 are connected to form a Wheatstone bridge circuit, which has a simple connection and may prevent current in the circuit from being too small/large due to too large/small resistance value of the fourth resistance element 314 resulted from deformation of the fourth resistance element 314. In this way, not only the circuit is protected, but accuracy of a voltage change amount acquired by the voltage acquisition unit 32 is also improved. In the following, for example, taking only one strain resistance element such as the fourth resistance element 314, a calculation for a deformation amount L of the fourth resistance element 314 is described. It is set that resistance values of the first resistance element 311, the second resistance element 312, the third resistance element 313 and the fourth resistance element 314 are R1, R2, R3 and R4 respectively, a voltage source EX voltage is VEX, and a voltage value acquired by the voltage acquisition unit 32 is $V_0$. It is known from a circuit principle of a Wheatstone bridge that:

$$V_o = \left[ \frac{R_3}{R_3+R_4} - \frac{R_2}{R_1+R_2} \right] V_{EX}$$

When there is no deformation, $R_4 = \rho \, \dfrac{l}{s}$ is known according to a relationship between a resistance value and a length of the fourth resistance element 314. Herein, *l* is an initial length of the fourth resistance element 314, s is an area of a cross section of the fourth resistance element 314, and ρ is a strain constant of the fourth resistance element 314.

When the bendable part 11 is bent and deformed, the deformation amount L of the fourth resistance element 314 can be obtained according to $V_O = \left[ \dfrac{R_3}{R_3 + \rho \frac{l+L}{s}} - \dfrac{R_2}{R_1 + R_2} \right] V_{EX}$ . Further, a ratio between the deformation amount L and length of the fourth resistance element 314 can be obtained, and thus a product of the length of the bendable part 11 and the ratio is acquired. The length of the bendable part 11 is subtracted from the product to obtain a deformation amount $\Delta l$ of the bendable part 11. Based on a thickness t of the rotating shaft mechanism, a deformation amount $\Delta L$ required to be adjusted of the rotating shaft mechanism can be obtained according to a formula of $\Delta L = \pi \cdot t + \Delta l$.

The first resistance element 311, the second resistance element 312, the third resistance element 313 and the fourth resistance element 314 are connected to form the Wheatstone bridge circuit, which serves as only one particular example of electrical connection between the first resistance element 311, the second resistance element 312, the third resistance element 313 and the fourth resistance element 314, and does not constitute a limitation. In another embodiment of the present disclosure, there may be another circuit connection structure, for which no more example is provided herein.

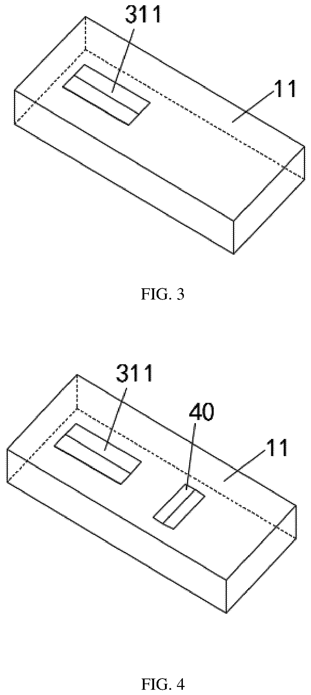

In this embodiment, there is one strain resistance element. As shown in FIG. 3, for example, taking the strain resistance element as the first resistance element 311, the first strain resistance element 311 is disposed in a one-fourth bridging manner. By using one strain resistance element, cost may be reduced. In addition, one strain resistance element is disposed in a one-fourth bridging manner, which has a relatively simple connection relationship, and can effectively simplify a producing process.

As shown in FIG. 4, in this embodiment, in order to eliminate the influence of temperature on the resistance value of the strain resistance element, a strain resistance element 40 of the same specification may be set on the flexible panel 10 for comparison, so as to eliminate the influence of temperature on the resistance value of the strain resistance element, and to improve measurement accuracy of the deformation amount of the bendable part 11.

In addition, in this embodiment, the flexible panel 10 is a flexible display panel including a pixel unit, and the strain gauge device 30 is electrically connected to a drive circuit of the pixel unit. When the flexible panel 10 is a flexible display panel, the strain gauge device 30 is configured to electrically connect to drive circuit of the pixel unit, and the strain gauge device 30 is powered directly through a pixel drive circuit of the flexible display panel. Therefore, it is not necessary to provide a additional power supply circuit for the strain gauge device 30, effectively simplifying a flexible module structure 100 and reducing preparation cost and processing requirement to the flexible module structure.

An embodiment of the present disclosure further provides a flexible module structure, in which the strain unit 31 includes two strain resistance elements, such as the first resistance element 311 and the second resistance element 312.

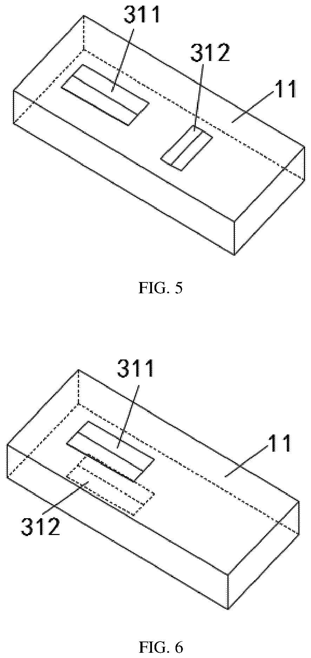

As shown in FIG. 5, it is set that the two strain resistance elements are the first resistance element 311 and the second resistance element 312 disposed in a half bridging manner and in the same plane.

Further, as shown in FIG. 6, the first resistance element 311 and the second resistance element 312 are oppositely disposed in two planes. It may be flexibly selected according to a practical need as to whether to dispose the first resistance element 311 and the second resistance element 3121 in the same plane or in two planes, but both can achieve the technical effect of measuring the deformation amount of the bendable part 11.

The first resistance element 311 and the second resistance element 312 are disposed on two arms connected in series of the Wheatstone bridge circuit, which is only one example for this embodiment but does not constitute a limitation. In another embodiment of the present disclosure, there may be another disposing manner. For example, the first resistance element 311 and the second resistance element 312 are disposed on two arms connected in parallel of the Wheatstone bridge circuit, and no more example is provided herein.

Because only an installation manner of the strain gauge device in the embodiment is changed, the present embodiment has the same technical effect for other unchanged parts, which is not repeated. In addition, the two strain resistance units of the first resistance element 311 and the second resistance element 312 are provided and can be compared to perform effective temperature compensation, thereby improving accuracy of a measurement result. In addition, the first resistance element 311 and the second resistance element 312 are disposed in a half bridging manner, further improving accuracy of the measurement result.

An embodiment of the present disclosure further relates to a flexible module structure. Herein, the first resistance element 311, the second resistance element 312, the third resistance element 313 and the fourth resistance element 314 are all strain resistance elements.

The four strain resistance elements are disposed in a full bridging manner.

The first resistance element 311, the second resistance element 312, the third resistance element 313 and the fourth resistance element 314 are disposed oppositely in a two-by-two manner.

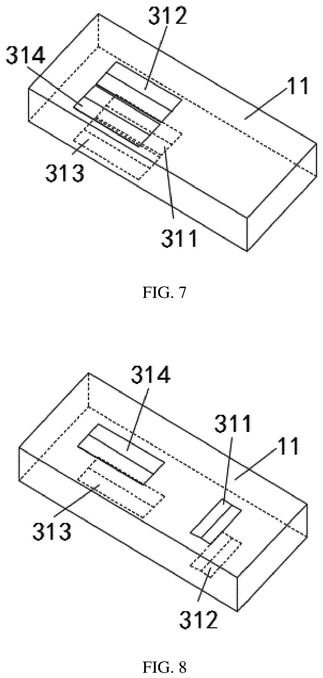

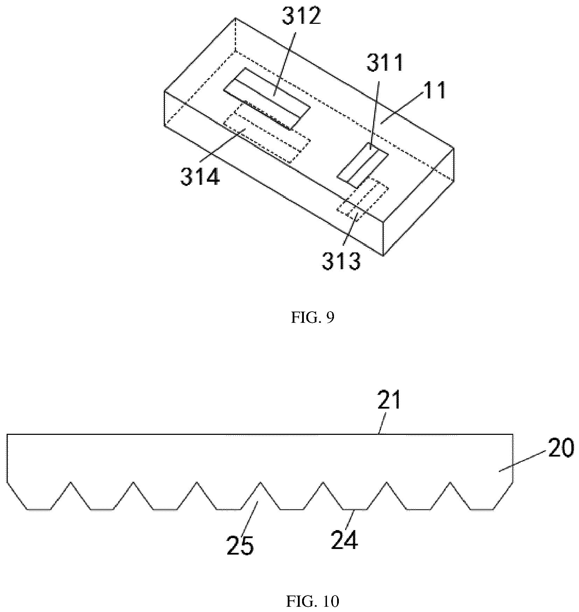

As shown in FIG. 7, the first resistance element 311 and the third resistance element 313 are disposed in the same plane, and the first resistance element 311 and the fourth resistance element 314 extend in the same direction; the second resistance element 312 and the fourth resistance element 314 are disposed in the same plane, and the second resistance element 312 and the fourth resistance element 314 extend in the same direction; the first resistance element 311 and the second resistance element 312 are disposed opposite to each other, and the third resistance element 313 and the fourth resistance element 314 are disposed opposite to each other. Alternatively, as shown in FIG. 8, the first resistance element 311 and the fourth resistance element 314 are disposed in the same plane and extend in different directions; the second resistance element 312 and the third resistance element 313 are disposed in the same plane and extend in different directions; the first resistance element 311 and the second resistance element 312 are disposed opposite to each other, and the third resistance element 313 and the fourth resistance element 314 are disposed opposite to each other. Alternatively, as shown in FIG. 9, the first resistance element 311 and the second resistance element 312 are disposed in the same plane and extend in different directions, and the third resistance element 313 and the fourth resistance element 314 are disposed in the same plane and extend in different directions; the first resistance element 311 and the third resistance element 313 are disposed opposite to each other, and the second resistance element 312 and the fourth resistance element 314 are disposed opposite to each other.

The first resistance element 311, the second resistance element 312, the third resistance element 313 and the fourth resistance element 314 are disposed oppositely in a two-by-two manner, which is only one example for this embodiment but does not constitute a limitation. In another embodiment of the present disclosure, there may be another disposing manner for which no more example is provided herein.

Because only an installation manner of the strain gauge device in the embodiment is changed, the present embodiment has the same technical effect for other unchanged parts, which is not repeated. In addition, in the third embodiment in the present disclosure, the four strain resistance units are disposed and can be compared to perform effective temperature compensation, thereby improving accuracy of the measurement result. In addition, the four strain resistance elements are disposed in a full bridging manner, further improving accuracy of the measurement result as compared with the one fourth bridging manner in an embodiment and the half bridging manner in the second embodiment.

In the following, properties of bridging manners of the strain gauge device 30 related to the above embodiments are described with reference to Table One, which may be chosen to use according to practical needs by those skilled in the art. The properties of the bridging manners are as shown in the following table. Herein Y denotes having this property and N denotes not having this property.

Table One

|  | FIG. 3 | FIG. 4 | FIG. 5 | FIG. 6 | FIG. 7 | FIG. 8 | FIG. 9 |
|---|---|---|---|---|---|---|---|
| Axial strain | Y | Y | Y | N | N | N | Y |
| Bending strain | Y | Y | Y | Y | Y | Y | N |
| Transverse sensitivity compensation | N | N | Y | N | N | Y | Y |
| Temperature compensation | N | Y | Y | Y | Y | Y | Y |
| Installation position | Located at a single side of a Wheatstone bridge | Located at a single side of a Wheatstone bridge | Located at a single side of a Wheatstone bridge | Located at two opposite sides of a Wheatstone bridge | Located at two opposite sides of a Wheatstone bridge | Located at two opposite sides of a Wheatstone bridge | Located at two opposite sides of a Wheatstone bridge |
| Wires provided | 2 or 3 | 3 | 3 | 3 | 4 | 4 | 4 |

As shown in Table One, the bridging manner shown in FIG. 3 has an axial strain and a bending strain, installation position thereof being single-sided, and wires provided being 2 or 3. The bridging manner shown in FIG. 4 has an axial strain and a bending strain, temperature compensation, installation position thereof being single-sided, and wires provided being 3. The bridging manner shown in FIG. 5 has an axial strain and a bending strain, temperature compensation and transverse sensitivity compensation, installation position thereof being single-sided, and wires provided being 3. The bridging manner shown in FIG. 6 has a bending strain, temperature compensation, installation position thereof being two-opposite-sided, and wires provided being 3. The bridging manner shown in FIG. 7 has a bending strain, temperature compensation, installation position thereof being two-opposite-sided, and wires provided being 4. The bridging manner shown in FIG. 8 has a bending strain, temperature compensation and transverse sensitivity compensation, installation position thereof being two-opposite-sided, and wires provided being 4. The bridging manner shown in FIG. 9 has an axial strain, temperature compensation and transverse sensitivity compensation, installation position thereof being two-opposite-sided, and wires provided being 4.

An embodiment of the present disclosure further relates to a flexible module structure. As shown in FIG. 10, the rotating shaft mechanism 20 includes a strain surface 24 disposed opposite to the contact surface 21, and the rotating shaft mechanism 20 includes a recess 25 protruding from the strain surface 24 towards the contact surface 21.

A shape of the recess 25 may be any shape such as a square or a cone or another shape not listed herein.

Further, in this embodiment, the recess 25 may be a groove parallel to a bending axis direction of the bendable part 11. In particular, the bending axis direction may be an extending direction of a bend axis when the bendable part 11 bends.

In the case that all technical effects of the above embodiments are maintained and recesses 25 protruding from the strain surface 24 towards the contact surface 21 are disposed on the rotating shaft mechanism 20, when the rotating shaft mechanism 20 has a buckling deformation, the recesses 25 can effectively reduce a stress of the strain surface 24, so that the neutral surface of the rotating shaft mechanism 20 gets closer to the contact surface 21.

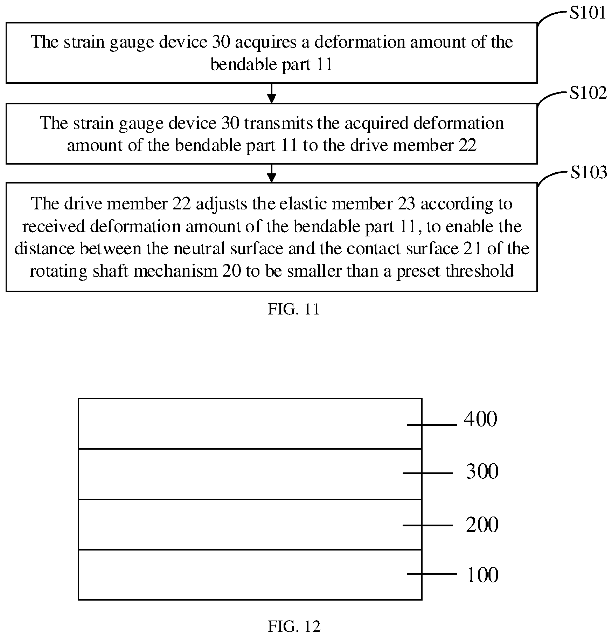

In the following, the operation principle of the flexible module structure provided in the embodiments of the present disclosure is described. The following is only a description on flows of detailed operation principle of components in the flexible module structure provided in the embodiments of the present disclosure, and does not constitute a limitation. As shown in FIG. 11, the following steps are included:

S101: the strain gauge device 30 acquires a deformation amount of the bendable part 11.

A particular implementation for the strain gauge device 30 to acquire the deformation amount of the bendable part 11 is already described in the embodiments and is not repeated.

S102: the strain gauge device 30 transmits the acquired deformation amount of the bendable part 11 to the drive member 22.

S103: the drive member 22 adjusts the elastic member 23 according to received deformation amount of the bendable part 11, to enable the distance between the neutral surface and the contact surface 21 of the rotating shaft mechanism 20 to be smaller than a preset threshold.

A particular implementation, in which the drive member 22 adjusts the elastic member 23 according to the received deformation amount of the bendable part 11 to enable the distance between the neutral surface and the contact surface 21 of the rotating shaft mechanism 20 to be smaller than a preset threshold, is already described in the embodiments and is not repeated.

An embodiment of the present disclosure relates to a display apparatus, as shown in FIG. 12, including: the flexible module structure 100 provided in the above, a film packaging layer 200 disposed on the flexible module structure 100 and a light transmitting layer 300 disposed on the film packaging layer 200.

Further, a polarizer 400 may be disposed on the film packaging layer 200.

Those skilled in the art may appreciate that the above embodiments are particular embodiments for implementing the present disclosure. In practice, however, the embodiments may change in terms of form and details, for example, by combining two or more embodiments, without departing from the spirit and scope of the present disclosure.

**Claims**

1. A flexible module structure, comprising:

    a flexible panel, having a bendable part;
    a rotating shaft mechanism, attached to a surface of the bendable part and comprising a contact surface attached to the surface of the bendable part; and
    a strain gauge device, at least partially disposed on the bendable part;
    wherein, when the bendable part has a buckling deformation, the strain gauge device is configured to acquire a deformation amount of the bendable part and give a feedback to the rotating shaft mechanism, and the rotating shaft mechanism is configured to reduce a distance between a neutral surface and the contact surface of the rotating shaft mechanism according to the deformation amount.

2. The flexible module structure according to claim 1, wherein the strain gauge device comprises a strain unit and a voltage acquisition unit electrically connected with the strain unit,
when the bendable part has a buckling deformation, the voltage acquisition unit is configured to acquire a voltage change value to acquire a resistance change value of the strain unit according to the voltage change value and acquire the deformation amount according to the resistance change value.

3. The flexible module structure according to claim 2, wherein the strain unit comprises at least four resistance elements that comprise at least one strain resistance element.

4. The flexible module structure according to claim 3, wherein the four resistance elements are connected to form a Wheatstone bridge circuit.

5. The flexible module structure according to claim 4, wherein the Wheatstone bridge circuit comprises a first arm and a second arm connected in series and a third arm and a fourth arm connected in series, one end of the voltage acquisition unit is electrically connected to a connecting point between the first arm and the second arm, and the other end of the voltage acquisition unit is electrically connected to a connecting point between the third arm and the fourth arm.

6. The flexible module structure according to claim 3, wherein the at least one strain resistance element comprises one strain resistance element disposed in a one-fourth bridging manner.

7. The flexible module structure according to claim 3, wherein the at least one strain resistance element comprises two strain resistance elements disposed in a half bridging manner.

8. The flexible module structure according to claim 7, wherein the two strain resistance elements are disposed at two arms connected in series of a Wheatstone bridge.

9. The flexible module structure according to claim 7, wherein the two strain resistance elements are disposed on two opposite surfaces of the bendable part.

10. The flexible module structure according to claim 3, wherein the at least one strain resistance element comprises four strain resistance elements disposed in a full bridging manner.

11. The flexible module structure according to claim 10, wherein two of the four strain resistance elements are disposed on a surface of the bendable part and the other two of the four strain resistance elements are correspondingly disposed on an opposite surface of the bendable part.

12. The flexible module structure according to any one of claims 1 to 11, wherein the flexible panel is a flexible display panel comprising a pixel unit, and the strain gauge device is electrically connected to a drive circuit of the pixel unit.

13. The flexible module structure according to claim 1, wherein the rotating shaft mechanism comprises a drive member and an elastic member connected to the drive member, and the drive member is configured to adjust the elastic member according to the deformation amount to reduce a distance between the neutral surface and the contact surface of the rotating shaft mechanism.

14. The flexible module structure according to claim 13, wherein the drive member is a motor, and the elastic member is a torsion spring.

15. The flexible module structure according to claim 1, wherein the rotating shaft mechanism comprises a strain surface disposed opposite to the contact surface, and the rotating shaft mechanism comprises a recess protruding from the strain surface towards the contact surface.

16. The flexible module structure according to claim 15, wherein the recess is a groove parallel to a bending axis direction of the bendable part.

**17.** A display apparatus, comprising:

the flexible module structure according to any one of claims 1 to 16;
a film packaging layer disposed on the flexible module structure; and
a light transmitting layer disposed on the film packaging layer.

FIG. 1

FIG. 2

FIG. 3

FIG. 4

311

312

11

FIG. 5

311

11

312

FIG. 6

FIG. 7

FIG. 8

FIG. 9

FIG. 10

S101

The strain gauge device 30 acquires a deformation amount of the bendable part 11

S102

The strain gauge device 30 transmits the acquired deformation amount of the bendable part 11 to the drive member 22

S103

The drive member 22 adjusts the elastic member 23 according to received deformation amount of the bendable part 11, to enable the distance between the neutral surface and the contact surface 21 of the rotating shaft mechanism 20 to be smaller than a preset threshold

FIG. 11

400

300

200

100

FIG. 12

## INTERNATIONAL SEARCH REPORT

| International application No. |
|---|
| **PCT/CN2019/113462** |

**A. CLASSIFICATION OF SUBJECT MATTER**

G09F 9/30(2006.01)i

According to International Patent Classification (IPC) or to both national classification and IPC

**B. FIELDS SEARCHED**

Minimum documentation searched (classification system followed by classification symbols)

G09F;G02F;H01L

Documentation searched other than minimum documentation to the extent that such documents are included in the fields searched

Electronic data base consulted during the international search (name of data base and, where practicable, search terms used)

WPI; EPODOC; CNKI; CNPAT: 柔性, 折叠, 显示, 屏, 应变, 应力, 中性, 中立, 分层, 剥离, 剥落, 惠斯通, 电桥, flexib+, fold +, display+, screen?, stress, strain, neutral+, delaminat+, peel+, wheatstone, bridge

**C. DOCUMENTS CONSIDERED TO BE RELEVANT**

| Category* | Citation of document, with indication, where appropriate, of the relevant passages | Relevant to claim No. |
|---|---|---|
| PX | CN 110060573 A (KUNSHAN GOVISIONOX OPTOELECTRONICS CO., LTD.) 26 July 2019 (2019-07-26)<br>claims 1-10, description, paragraphs [0004]-[0081], and figures 1-12 | 1-17 |
| Y | CN 107195253 A (WUHAN TIANMA MICRO-ELECTRONICS CO., LTD.) 22 September 2017 (2017-09-22)<br>description, paragraphs [0031]-[0073], and figures 2-12 | 1-17 |
| Y | CN 106505156 A (LG DISPLAY CO., LTD.) 15 March 2017 (2017-03-15)<br>description, paragraphs [0042]-[0045] and [0066]-[0067], and figure 1 | 1-17 |
| Y | CN 109584725 A (SHANGHAI TIANMA ORGANIC LUMINESCENT DISPLAY TECHNOLOGY CO., LTD.) 05 April 2019 (2019-04-05)<br>description, paragraphs [0065] and [0107]-[0117], and figures 3-24 | 2-11 |
| A | CN 106773185 A (DONGXU (KUNSHAN) DISPLAY MATERIAL CO., LTD. et al.) 31 May 2017 (2017-05-31)<br>entire document | 1-17 |
| A | CN 108447433 A (XIAMEN TIANMA MICRO-ELECTRONICS CO., LTD.) 24 August 2018 (2018-08-24)<br>entire document | 1-17 |

☑ Further documents are listed in the continuation of Box C.      ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **07 January 2020** | **23 January 2020** |

| Name and mailing address of the ISA/CN | Authorized officer |
|---|---|
| **China National Intellectual Property Administration**<br>**No. 6, Xitucheng Road, Jimenqiao Haidian District, Beijing**<br>**100088**<br>**China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2019/113462** |

**C.     DOCUMENTS CONSIDERED TO BE RELEVANT**

| Category* | Citation of document, with indication, where appropriate, of the relevant passages | Relevant to claim No. |
| --- | --- | --- |
| A | CN 208737802 U (ROYOLE CORPORATION) 12 April 2019 (2019-04-12)<br>entire document | 1-17 |
| A | CN 105845700 A (INDUSTRIAL TECHNOLOGY RESEARCH INSTITUTE) 10 August 2016 (2016-08-10)<br>entire document | 1-17 |
| A | TW I622832 B (PRIME VIEW INTERNATIONAL CO., LTD.) 01 May 2018 (2018-05-01)<br>entire document | 1-17 |

Form PCT/ISA/210 (second sheet) (January 2015)

## INTERNATIONAL SEARCH REPORT
### Information on patent family members

International application No.

**PCT/CN2019/113462**

| Patent document cited in search report | | | Publication date (day/month/year) | Patent family member(s) | | | Publication date (day/month/year) |
|---|---|---|---|---|---|---|---|
| CN | 110060573 | A | 26 July 2019 | None | | | |
| CN | 107195253 | A | 22 September 2017 | None | | | |
| CN | 106505156 | A | 15 March 2017 | EP | 3136459 | A1 | 01 March 2017 |
| | | | | US | 9960375 | B2 | 01 May 2018 |
| | | | | US | 10505131 | B2 | 10 December 2019 |
| | | | | US | 2018212170 | A1 | 26 July 2018 |
| | | | | US | 10263204 | B2 | 16 April 2019 |
| | | | | CN | 110071141 | A | 30 July 2019 |
| | | | | US | 2019181366 | A1 | 13 June 2019 |
| | | | | EP | 3136459 | B1 | 09 October 2019 |
| | | | | CN | 106505156 | B | 29 March 2019 |
| | | | | US | 2017062741 | A1 | 02 March 2017 |
| | | | | KR | 20190110986 | A | 01 October 2019 |
| | | | | KR | 102028008 | B1 | 02 October 2019 |
| | | | | KR | 20170026055 | A | 08 March 2017 |
| CN | 109584725 | A | 05 April 2019 | None | | | |
| CN | 106773185 | A | 31 May 2017 | None | | | |
| CN | 108447433 | A | 24 August 2018 | None | | | |
| CN | 208737802 | U | 12 April 2019 | None | | | |
| CN | 105845700 | A | 10 August 2016 | US | 9775234 | B2 | 26 September 2017 |
| | | | | US | 2016143130 | A1 | 19 May 2016 |
| | | | | TW | 201620129 | A | 01 June 2016 |
| | | | | TW | I550850 | B | 21 September 2016 |
| TW | I622832 | B | 01 May 2018 | TW | 201901252 | A | 01 January 2019 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910323557